# EUROPEAN PATENT APPLICATION

(11) **EP 4 492 938 A2**
(43) Date of publication of application: **15.01.2025**
(21) Application number: 24186745.6
(22) Date of filing: 05.07.2024
(51) Int. Cl.: H10B 12/00

(54) **SEMICONDUCTOR DEVICE AND METHOD OF MANUFACTURING THE SAME**

(30) Priority: 14.07.2023 KR 20230092032
(71) Applicant: Samsung Electronics Co., Ltd., Suwon-si, Gyeonggi-do 16677 (KR)
(72) Inventor: KANG, Yoongoo, 16677 Suwon-si, Gyeonggi-do (KR); LEE, Hyunjung, 16677 Suwon-si, Gyeonggi-do (KR); PARK, Jaehong, 16677 Suwon-si, Gyeonggi-do (KR)
(74) Representative: Kuhnen & Wacker Patent- und Rechtsanwaltsbüro PartG mbB

(57) **Abstract**

Provided is a semiconductor device 100 including a peripheral circuit structure PS including peripheral circuit transistors 60TR, bit lines BL on the peripheral circuit structure PS and extending in a first horizontal direction Y, back gate lines 130 extending in a second horizontal direction X at a vertical level higher than the bit lines BL, word lines WL extending in the second horizontal direction X at a vertical level higher than the bit lines BL and alternating with the back gate lines 130, a plurality of vertical channel layers 140 in a matrix form on the bit lines BL, each of the vertical channel layers 140 including a first sidewall SW1 extending in a vertical direction Z and facing a corresponding back gate line 130, a second sidewall SW2 opposite to the first sidewall SW1 and facing a corresponding word line WL, a part of the second sidewall SW2 adjacent to a bit line BL having a curved shape, contact pads 170 on the vertical channel layers 140, and storage nodes 180 on the contact pads 170.

## Description

### BACKGROUND

Embodiments of the present disclosure relate to a semiconductor device and a method of manufacturing the same, and more particularly, to a semiconductor device including a vertical channel transistor and a manufacturing method thereof.

Based on the downscaling of the semiconductor device, the size of a dynamic random access memory (DRAM) device is also being reduced. In a DRAM device with a one transistor-one capacitor (1T-1C) structure in which one capacitor is connected to one transistor, there is a problem that the leakage current through a channel region increases as the device is miniaturized. In order to reduce the leakage current, a vertical channel transistor including a channel layer extending in a vertical direction has been proposed.

### SUMMARY

One or more embodiments provide a semiconductor device having improved electrical performance.

One or more embodiments also provide a method of manufacturing a semiconductor device having improved electrical performance.

According to an aspect of an embodiment, there is provided a semiconductor device including a peripheral circuit structure including peripheral circuit transistors, a plurality of bit lines on the peripheral circuit structure and extending in a first horizontal direction, a plurality of back gate lines extending in a second horizontal direction at a vertical level higher than a vertical level of the plurality of bit lines, a plurality of word lines extending in the second horizontal direction at a vertical level higher than the vertical level of the plurality of bit lines and alternating with the plurality of back gate lines, a plurality of vertical channel layers in a matrix form on the plurality of bit lines, each of the plurality of vertical channel layers including a first sidewall extending in a vertical direction and facing a corresponding back gate line among the plurality of back gate lines, a second sidewall opposite to the first sidewall and facing a corresponding word line among the plurality of word lines, a part of the second sidewall adjacent to a bit line among the plurality of bit lines having a curved shape, a plurality of contact pads on the plurality of vertical channel layers, and a plurality of storage nodes on the plurality of contact pads.

According to another aspect of an embodiment, there is provided a semiconductor device including a plurality of bit lines on a substrate and extending in a first horizontal direction, a plurality of back gate lines extending in a second horizontal direction at a vertical level higher than a vertical level of the plurality of bit lines, a plurality of word lines extending in the second horizontal direction at a vertical level higher than the vertical level of the plurality of bit lines and alternating with the plurality of back gate lines, a plurality of vertical channel layers extending in a vertical direction on the plurality of bit lines, each of the plurality of vertical channel layers including a first sidewall extending in the vertical direction and facing a corresponding back gate line among the plurality of back gate lines, a second sidewall opposite to the first sidewall and facing a corresponding word line among the plurality of word lines, a first end in contact with a bit line among the plurality of bit lines, and a second end opposite to the first end, the second sidewall having a convex curved shape toward the corresponding word line among the plurality of word lines at a position adjacent to the first end, a plurality of contact pads on the plurality of vertical channel layers, and a plurality of storage nodes on the plurality of contact pads, wherein a first width of the first end in the first horizontal direction is less than a second width of the second end in the first horizontal direction.

According to another aspect of an embodiment, there is provided a semiconductor device including a peripheral circuit structure including peripheral circuit transistors, a plurality of bit lines on the peripheral circuit structure and extending in a first horizontal direction, a plurality of back gate lines extending in a second horizontal direction at a vertical level higher than a vertical level of the plurality of bit lines, a plurality of word lines extending in the second horizontal direction at a vertical level higher than the vertical level of the plurality of bit lines and alternating with the plurality of back gate lines, a plurality of vertical channel layers in a matrix form on the plurality of bit lines, each of the plurality of vertical channel layers including a first sidewall extending in a vertical direction and facing a corresponding back gate line among the plurality of back gate lines, a second sidewall opposite to the first sidewall and facing a corresponding word line among the plurality of word lines, a part of the second sidewall adj acent to the bit line having a curved shape, a gate insulation layer between each of the plurality of vertical channel layers and the corresponding word line, a spacer between each of the plurality of vertical channel layers and the corresponding back gate line, a plurality of contact pads on the plurality of vertical channel layers, and a plurality of storage nodes on the plurality of contact pads.

According to another aspect of an embodiment, there is provided a method of manufacturing a semiconductor device, the method including forming a plurality of line patterns extending in a first horizontal direction on a substrate, the plurality of line patterns each including a back gate line and spacers on both sidewalls of the back gate line, forming a preliminary channel layer on the plurality of line patterns that are on the substrate, performing a laser annealing process on the preliminary channel layer to crystallize the preliminary channel layer into a single crystal, removing a portion of the preliminary channel layer on a first surface of each of the plurality of line patterns, and removing a portion of the preliminary channel layer on the substrate, and leaving a portion of the preliminary channel layer on the sidewalls of the plurality of line patterns, and removing a portion of the preliminary channel layer to form a plurality of channel layers spaced apart from each other in the first horizontal direction.

According to an aspect of an embodiment, there is provided a semiconductor device. The semiconductor device may include a peripheral circuit structure including peripheral circuit transistors. The semiconductor device may include a plurality of bit lines, e.g. on the peripheral circuit structure and/or on a substrate, and extending in a first horizontal direction. The semiconductor device may include a plurality of back gate lines extending in a second horizontal direction at a vertical level higher than a vertical level of the plurality of bit lines. The semiconductor device may include a plurality of word lines extending in the second horizontal direction at a vertical level higher than the vertical level of the plurality of bit lines and alternating with the plurality of back gate lines. The semiconductor device may include a plurality of vertical channel layers, e.g. in a matrix form and/or extending in a vertical direction, on the plurality of bit lines. Each of the plurality of vertical channel layers may comprise a first sidewall extending in the vertical direction and facing a corresponding back gate line among the plurality of back gate lines. Each of the plurality of vertical channel layers may comprise a second sidewall opposite to the first sidewall and facing a corresponding word line among the plurality of word lines. A part of the second sidewall adjacent to a bit line among the plurality of bit lines may have a curved shape. Each of the plurality of vertical channel layers may comprise a first end in contact with a bit line among the plurality of bit lines. Each of the plurality of vertical channel layers may comprise a second end opposite to the first end. For example, the second sidewall has a convex curved shape toward the corresponding word line among the plurality of word lines at a position adjacent to the first end. The semiconductor device may include a plurality of contact pads on the plurality of vertical channel layers. The semiconductor device may include a plurality of storage nodes on the plurality of contact pads. A first width of the first end in the first horizontal direction may be less than a second width of the second end in the first horizontal direction.

### BRIEF DESCRIPTION OF THE DRAWINGS

Embodiments will be more clearly understood from the following detailed description taken in conjunction with the accompanying drawings in which:
FIG. 1 is a perspective view schematically illustrating a semiconductor device according to embodiments;
FIG. 2 is an enlarged layout diagram of a portion of a cell array region of FIG. 1;
FIG. 3 is a cross-sectional view taken along line A1-A1' of FIG. 2;
FIG. 4 is an enlarged view of a portion CX1 of FIG. 3;
FIG. 5 is a schematic plan view at a first vertical level of FIG. 3;
FIG. 6 is a cross-sectional view illustrating a semiconductor device according to embodiments;
FIG. 7 is an enlarged view of a portion CX1 of FIG. 6;
FIG. 8 is a cross-sectional view illustrating a semiconductor device according to embodiments;
FIG. 9 is an enlarged view of a portion CX1 of FIG. 8;
FIG. 10 is a cross-sectional view illustrating a semiconductor device according to embodiments;
FIG. 11 is an enlarged view of a portion CX1 of FIG. 10;
FIG. 12 is a schematic plan view at a first vertical level of FIG. 10;
FIG. 13 is a cross-sectional view illustrating a semiconductor device according to embodiments;
FIG. 14 is an enlarged view of a portion CX1 of FIG. 13;
FIG. 15 is a schematic plan view at a first vertical level of FIG. 13;
FIGS. 16, 17, 18, 19, 20A, 20B, 21A, 21B, 22, 23, 24A, 24B, 25, 26, 27, and 28 are schematic diagrams illustrating a method of manufacturing a semiconductor device, according to embodiments, in which FIGS. 16 to 19, 20A, 21A, 22, 23, 24A, and 25 to 28 are cross-sectional views taken along line A1-A1' of FIG. 2, and FIGS. 20B, 21B, and 24B are plan views at a first vertical level of FIGS. 20A, 21A, and 24A;
FIG. 29 is a cross-sectional view illustrating a method of manufacturing a semiconductor device, according to embodiments; and
FIGS. 30A, 30B, 31A, 31B, and 32 are schematic diagrams illustrating a method of manufacturing a semiconductor device, according to embodiments, in which FIGS. 30A, 31A, and 32 are cross-sectional views taken along line A1-A1' of FIG. 2, and FIGS. 30B and 31B are plan views at a first vertical level of FIGS. 30A and 31A.

### DETAILED DESCRIPTION

Embodiments described herein are example embodiments, and thus, the disclosure is not limited thereto.

It will be understood that, although the terms first, second, third, fourth, etc. may be used herein to describe various elements, components, regions, layers and/or sections (collectively "elements"), these elements should not be limited by these terms. These terms are only used to distinguish one element from another element. Thus, a first element described in this description section may be termed a second element or vice versa in the claim section without departing from the teachings of the disclosure.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

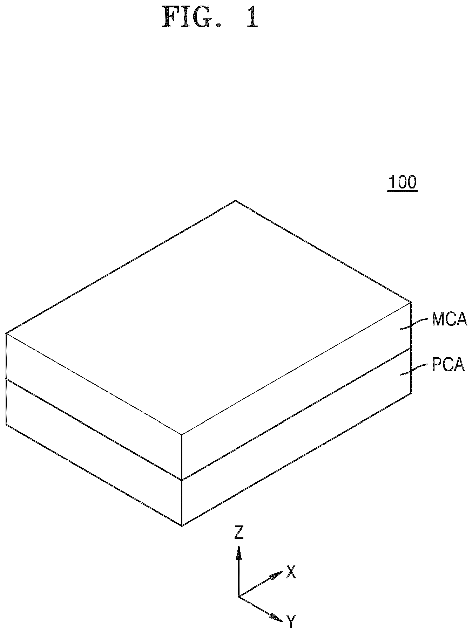

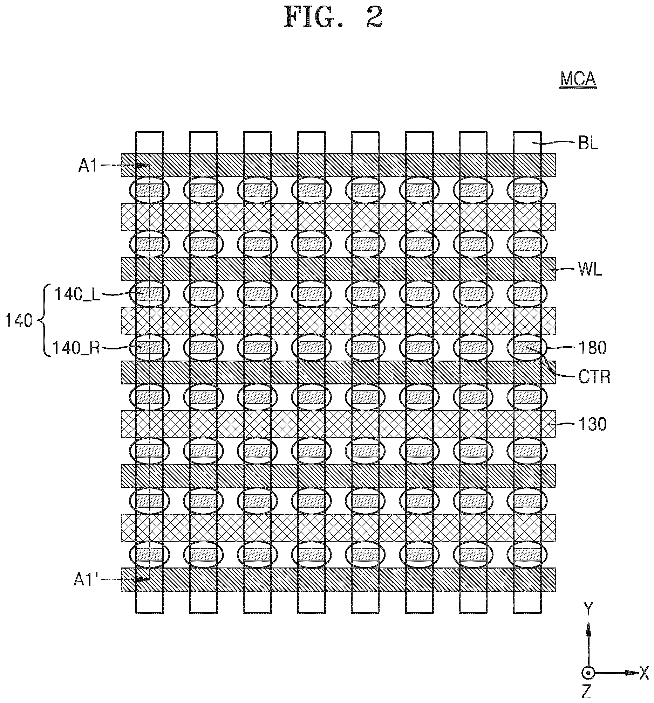

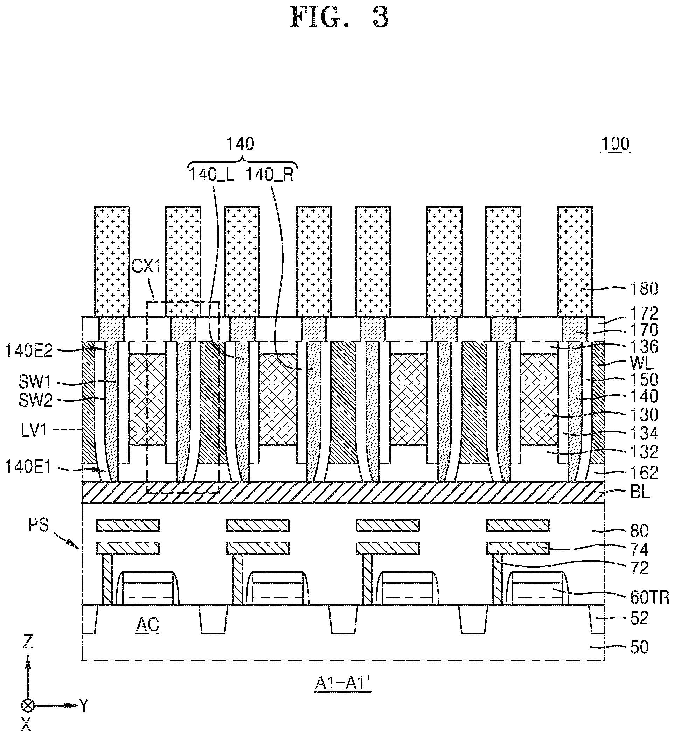

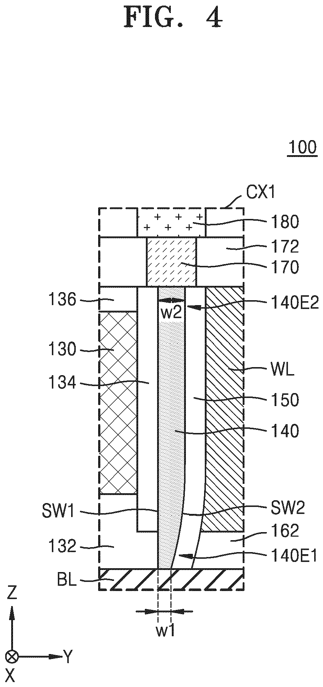

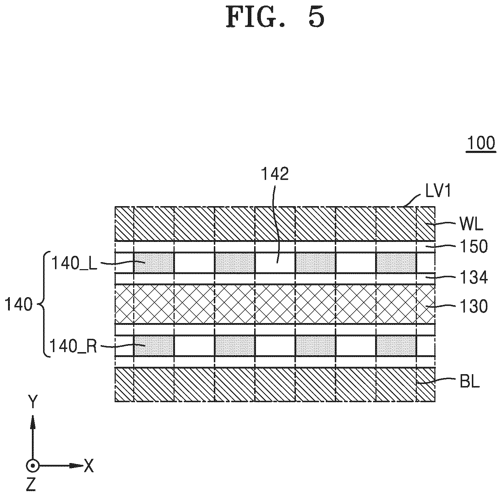

FIG. 1 is a perspective view schematically illustrating a semiconductor device 100 according to embodiments. FIG. 2 is an enlarged layout diagram of a portion of a cell array region MCA of FIG. 1. FIG. 3 is a cross-sectional view taken along line A1-A1' of FIG. 2. FIG. 4 is an enlarged view of a portion CX1 of FIG. 3. FIG. 5 is a schematic plan view at a first vertical level LV1 of FIG. 3.

Referring to FIGS. 1 to 5, the semiconductor device 100 may include a cell array region MCA and a peripheral circuit region PCA arranged at different vertical levels. The peripheral circuit region PCA and the cell array region MCA may overlap each other in a vertical direction. For example, the cell array region MCA may be placed on the peripheral circuit region PCA as shown in FIG. 1, and the semiconductor device 100 may have a cell over periphery (COP) structure.

In some embodiments, the cell array region MCA may be a memory cell region of a DRAM device, and the peripheral circuit region PCA may be a core region or a peripheral circuit region of the DRAM device. For example, the peripheral circuit region PCA may include a peripheral circuit transistor 60TR (see FIG. 3) for transmitting signals and/or power to a memory cell array included in the cell array region MCA. In embodiments, the peripheral circuit transistor 60TR may include various circuits such as a command decoder, a control logic, an address buffer, a row decoder, a column decoder, a sense amplifier, and a data input/output circuit.

As illustrated in FIG. 2, a plurality of word lines WL and a plurality of back gate lines 130 may be alternately arranged in the cell array region MCA to extend in a first horizontal direction X. In addition, a plurality of bits lines BL may extend in the second horizontal direction Y. On the plurality of bit lines BL, a plurality of cell transistors CTR may be arranged between each of the plurality of word lines WL and each of the back gate lines 130 adjacent to the plurality of word lines WL. The plurality of cell transistors CTR may be arranged in a matrix form in the first horizontal direction X and the second horizontal direction Y. A plurality of storage nodes 180 may be arranged on the plurality of cell transistors CTR, respectively.

The peripheral circuit structure PS may include a substrate 50 and a peripheral circuit transistor 60TR arranged on the substrate 50.

The substrate 50 may include silicon, for example, single crystalline silicon, polycrystalline silicon, or amorphous silicon. In some other embodiments, the substrate 50 may include at least one selected from germanium (Ge), silicon germanium (SiGe), silicon carbon (SiC), gallium arsenide (GaAs), indium arsenide (InAs), and indium phosphide (InP). A device isolation layer 52 may be formed on the substrate 50, and an active region AC may be defined by the device isolation layer 52.

A peripheral circuit transistor 60TR may be arranged on the active region AC of the substrate 50. The peripheral circuit transistor 60TR may include, for example, at least one of a planar type transistor, a finFET, a multi-bridge channel transistor, and a buried channel array transistor.

A peripheral circuit contact 72 and a peripheral circuit wiring layer 74 may be arranged on the substrate 50, and the peripheral circuit contact 72 and the peripheral circuit wiring layer 74 may be electrically connected to the peripheral circuit transistor 60TR. An interlayer insulation layer 80 covering the peripheral circuit transistor 60TR, the peripheral circuit contact 72, and the peripheral circuit wiring layer 74 may be arranged on the substrate 50.

The peripheral circuit structure PS may correspond to the peripheral circuit region PCA of FIG. 1, and for example, the peripheral circuit transistor 60TR may be configured to apply a driving signal or a driving voltage to at least one of the bit line BL, word line WL, and back gate line 130 arranged in the cell array region MCA vertically overlapping the peripheral circuit structure PS.

The plurality of bit lines BL extending in the second horizontal direction Y may be arranged on the interlayer insulation layer 80. In some embodiments, the bit line BL may include titanium (Ti), titanium nitride (TiN), tantalum (Ta), tantalum nitride (TaN), molybdenum (Mo), molybdenum nitride (MoN), ruthenium (Ru), tungsten (W), tungsten nitride (WN), cobalt (Co), titanium silicon nitride (TiSiN), tungsten silicon nitride (WSiN), polysilicon, or a combination thereof. Bit line isolation layers may be arranged to extend in the second horizontal direction Y between the plurality of bit lines BL. For example, the bit line isolation layer may be formed at the same height as the bit line BL in the vertical direction Z, while filling a space between two adjacent bit lines BL.

A plurality of back gate lines 130 may be arranged to extend in the first horizontal direction X on the plurality of bit lines BL and the bit line isolation layers. A buried insulation layer 132 may be arranged on a bottom surface of the back gate line 130, and a first insulation layer 136 may be arranged on a top surface of the back gate line 130. The buried insulation layer 132 and the first insulation layer 136 may be arranged on the top and bottom surfaces of the back gate line 130, respectively, and may extend in an extension direction of the back gate line 130 (e.g., the first horizontal direction X). The buried insulation layer 132 may be arranged between the back gate line 130 and each of the plurality of bit lines BL and between the back gate line 130 and the bit line isolation layer, and the plurality of bit lines BL and the plurality of back gate lines 130 may be separated by the buried insulation layers 132 in a vertical direction Z and electrically insulated from each other.

Spacers 134 may be arranged on both sidewalls of the plurality of back gate lines 130. The spacer 134 may have a top surface arranged at the same level as the top surface of the first insulation layer 136 and may have a bottom surface arranged at a lower level than the bottom surface of the back gate line 130, and a bottom surface of the spacer 134 may contact the buried insulation layer 132. The spacer 134 may cover or contact both sidewalls of the back gate line 130.

Each of the plurality of back gate lines 130 may include Ti, TiN, Ta, TaN, Mo, MoN, Ru, W, WN, Co, TiSiN, WSiN, or a combination thereof. In some embodiments, the plurality of back gate lines 130 may include a conductive barrier layer and a metal buried layer, and the conductive barrier layer may be placed at an interface between the spacer 134 and the back gate line 130 and/or an interface between the first insulation layer 136 and the back gate line 130, and the top surface and sidewalls of a metal buried layer may be covered by the conductive barrier layer.

A plurality of vertical channel layers 140 may be arranged on the plurality of bit lines BL to extend in the vertical direction Z on the sidewalls of the buried insulation layer 132 and the spacer 134. The plurality of vertical channel layers 140 may be spaced apart in the first horizontal direction X and the second horizontal direction Y and arranged in a matrix form, and each of the plurality of vertical channel layers 140 may extend in the vertical direction Z on the top surface of each of the plurality of bit lines BL.

Each vertical channel layer 140 may include a first vertical channel layer 140_L arranged on a first side of each back gate line 130. Each vertical channel layer 140 may also include a second vertical channel layer 140_R arranged on a second side of each back gate line 130 and arranged adjacent to the first vertical channel layer 140_L in the second horizontal direction Y. The first vertical channel layer 140_L and the second vertical channel layer 140_R may be symmetrical with respect to each other. For example, the first vertical channel layer 140_L and the second vertical channel layer 140_R may be symmetrical with respect to each other along the center line of the back gate line 130 arranged between the first vertical channel layer 140_L and the second vertical channel layer 140_R.

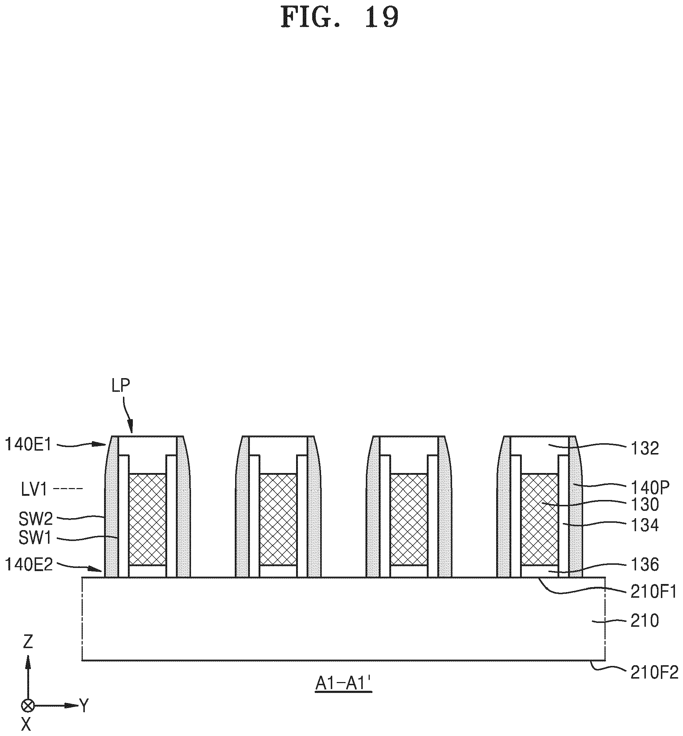

In embodiments, the plurality of vertical channel layers 140 may include single crystal silicon. For example, the vertical channel layer 140 may include single crystal silicon crystallized by performing a laser annealing process on a preliminary channel layer 140P formed of amorphous silicon (see FIG. 19). In some embodiments, crystal defects such as stacking faults or dislocations may exist inside the vertical channel layer 140. In some embodiments, crystal defects observed inside the vertical channel layer 140 may be observed by measurement equipment such as transmission electron microscopy (TEM) or scanning electron microscopy (SEM). For example, the crystal defects may refer to a local region that has lost regularity, observed inside the single crystal silicon of the vertical channel layer 140.

Each vertical channel layer 140 may include a first end 140E1 in contact with the bit line BL and a second end 140E2 arranged on the opposite side of the first end 140E1. The second end 140E2 of each of the plurality of vertical channel layers 140 may be a part of the vertical channel layer 140 arranged furthest from the bit line BL. A first width w1 of the first end 140E1 of each of the plurality of vertical channel layers 140 may be greater than a second width w2 of the second end 140E2 in the second horizontal direction Y.

Each of the plurality of vertical channel layers 140 may include a first sidewall SW1 facing the back gate line 130 and a second sidewall SW2 opposite to the first sidewall SW1. At the first end 140E1 of each of the plurality of vertical channel layers 140, the first sidewall SW1 may extend substantially vertically. At the first end 140E1 of each of the plurality of vertical channel layers 140, the second sidewall SW2 may have a curved shape. For example, the second sidewall SW2 may have a curved shape, which is convex outward toward a corresponding word line WL.

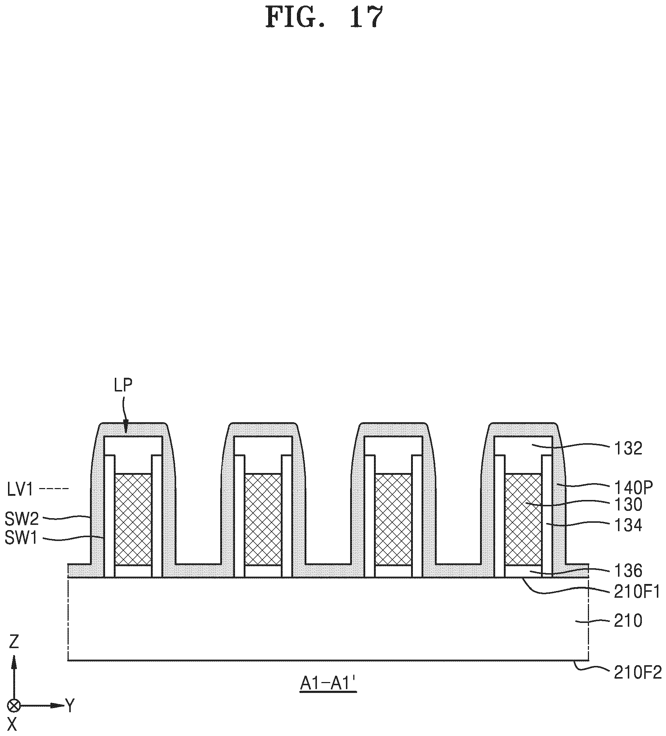

In embodiments, a preliminary channel layer 140P (see FIGS. 17 to 20B) may be formed on the sidewalls of the spacer 134 and the buried insulation layer 132, and an anisotropic etching process may be performed to separate the preliminary channel layer 140P into a plurality of vertical channel layers 140. The convex curved shape of the second sidewall SW2 may be a resultant structure formed by relatively long exposure of a part adjacent to the first end 140E1 of the vertical channel layer 140 to an etching atmosphere during the anisotropic etching process.

A gate insulation layer 150 may be arranged on the second sidewall SW2 of each of the plurality of vertical channel layers 140. The gate insulation layer 150 may conformally extend from the sidewall of the second end 140E2 of each of the plurality of vertical channel layers 140 to the sidewall of the first end 140E1, and may extend along the convex curved shape of the second sidewall SW2 of the vertical channel layer 140. In embodiments, the gate insulation layer 150 may include at least one of silicon oxide, silicon nitride, or high-k metal oxide.

In some embodiments, the gate insulation layer 150 may be formed of at least one selected from hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), silicon oxynitride (ZrON), zirconium silicon oxynitride (ZrSiON), tantalum oxide (TaO), titanium oxide (TiO), barium strontium titanium oxide (BaSrTiO), barium titanium oxide (BaTiO), lead titanate zirconate (PbZrTiO), tantalate strontium bismuth (SrTaBiO), bismuth iron oxide (BiFeO), strontium titanium oxide (SrTiO), yttrium oxide (YO), aluminum oxide (AlO), and lead scandium tantalum oxide (PbScTaO).

The plurality of word lines WL may extend in the first horizontal direction X on the sidewall of the gate insulation layer 150. The top surface of each of the plurality of word lines WL may be arranged at the same level as the top surface of each of the plurality of gate insulation layers 150, and a second insulation layer 162 may be arranged on the bottom surface of each of the plurality of word lines WL. The second insulation layer 162 may extend in the extension direction (e.g., the first horizontal direction X) of each of the plurality of word lines WL and may electrically separate each of the plurality of word lines WL from each of the plurality of bit lines BL. In some embodiments, the word line WL may include Ti, TiN, Ta, TaN, Mo, Ru, W, WN, TiSiN, WSiN, polysilicon, or a combination thereof.

The plurality of word lines WL may be alternately arranged with the plurality of back gate lines 130 and may extend in the first horizontal direction X, and each cell transistor CTR may have a dual gate structure including one word line WL and one back gate line 130 as a gate electrode. For example, as shown in FIG. 3, one word line WL is arranged on the left side of the first vertical channel layer 140_L, and the gate insulation layer 150 is arranged between the first vertical channel layer 140_L and the one word line WL. In addition, one back gate line 130 is arranged on the right side of the first vertical channel layer 140_L, and the spacer 134 is arranged between the first vertical channel layer 140_L and the one back gate line 130. The first vertical channel layer 140_L may function as a vertical channel shared by the word line WL arranged on the left side thereof and the back gate line 130 arranged on the right side thereof, and a dual gate type vertical transistor may be implemented.

As illustrated in FIG. 5, a channel layer separation insulation layer 142 may be arranged between the vertical channel layers 140 adjacent to each other in the first horizontal direction X. For example, the vertical channel layers 140 and the channel layer separation insulation layers 142 may be alternately and repeatedly arranged in the space between the gate insulation layer 150 and the spacer 134.

A contact pad 170 may be arranged on each of the plurality of vertical channel layers 140. An interlayer insulation layer 172 may be arranged on the top surfaces of the first insulation layer 136, the gate insulation layer 150, and the word line WL and may be adjacent to and surround the sidewall of the contact pad 170. A storage node 180 may be arranged on the contact pad 170.

In some embodiments, the contact pad 170 may include Ti, TiN, Ta, TaN, Mo, MoN, Ru, W, WN, Co, TiSiN, WSiN, polysilicon or a silicide material thereof. In some embodiments, the storage node 180 may include a metal-insulator-metal (MIM) capacitor. In some other embodiments, the storage node 180 may include a memory component such as a variable resistance memory device, a phase change memory device, and a magnetic memory device.

In some embodiments, impurities may be further doped on a portion of the first end 140E1 of the vertical channel layer 140 contacting the bit line BL and/or on a portion of the second end 140E2 of the vertical channel layer 140 contacting the contact pad 170, and the portion of the first end 140E1 and the portion of the second end 140E2, which are doped with impurities, may function as a source/drain region of the cell transistor CTR, respectively.

In general, in order to improve the integration of memory cells of DRAM devices, a 1T-1C type DRAM device in which vertical channel transistors and storage nodes are connected to each other has been proposed. However, since a silicon layer is patterned using a silicon-on-insulator (SOI) type substrate to form a vertical channel with improved crystal quality, etching damage may occur in a patterning process of the silicon layer and manufacturing cost may increase.

However, according to embodiments, a back gate line and a preliminary channel layer may be formed on a bulk silicon substrate, and a laser annealing process may be performed on the preliminary channel layer to crystallize the preliminary channel layer into a single crystal to thereby form a vertical channel layer 140. The crystal quality of the vertical channel layer 140 crystallized by the laser annealing process may be improved, so that the semiconductor device 100 may have improved electrical performance. In addition, the manufacturing cost of the semiconductor device 100 may be reduced by using a bulk silicon substrate.

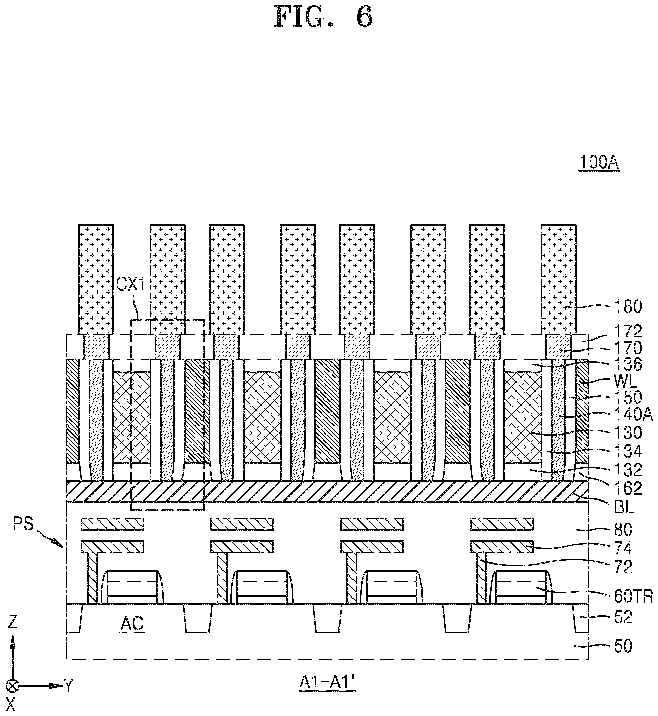

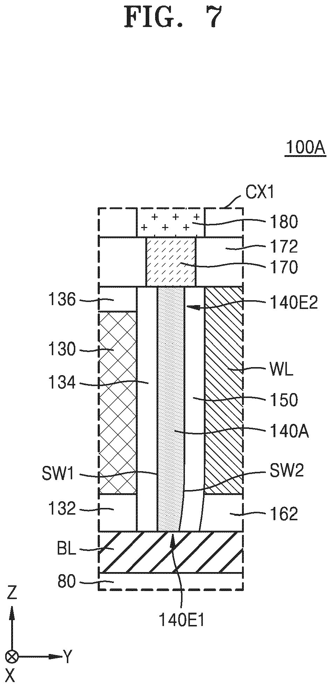

FIG. 6 is a cross-sectional view illustrating a semiconductor device 100A according to embodiments. FIG. 7 is an enlarged view of a portion CX1 of FIG. 6. In FIGS. 6 and 7, the same reference numerals as in FIGS. 1 to 5 indicate the same components.

Referring to FIGS. 6 and 7, a bottom surface of the buried insulation layer 132 and a bottom surface of the spacer 134 may be arranged at the same level as a bottom surface of the first end 140E1 of the vertical channel layer 140A. The bottom surface of the buried insulation layer 132, the bottom surface of the spacer 134, and the bottom surface of the first end 140E1 of the vertical channel layer 140A may contact the top surface of the bit line BL.

According to embodiments, when compared to the embodiments described with reference to FIGS. 1 to 4, a portion of the first end 140E1 of the vertical channel layer 140A may be removed by a planarization process, and thus, a portion of the convex curved shape of the second sidewall SW2 of the vertical channel layer 140A may be removed together. As the portion of the convex curved shape of the second sidewall SW2 of the vertical channel layer 140A is removed, a contact area between the first end 140E1 of the vertical channel layer 140A and the bit line BL may be increased.

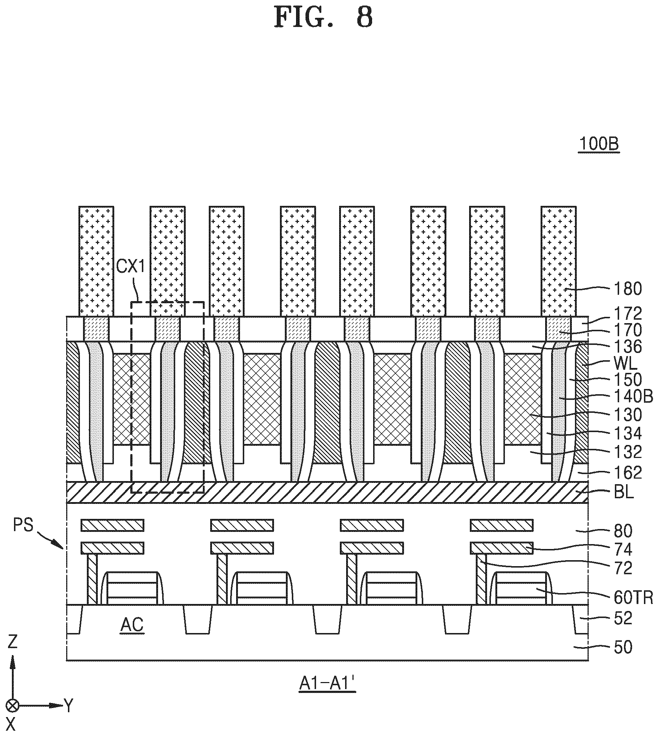

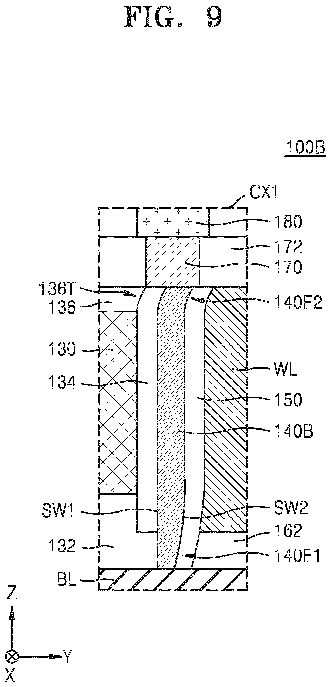

FIG. 8 is a cross-sectional view illustrating a semiconductor device 100B according to embodiments. FIG. 9 is an enlarged view of a portion CX1 of FIG. 8. In FIGS. 8 and 9, the same reference numerals as in FIGS. 1 to 7 indicate the same components.

Referring to FIGS. 8 and 9, a tail portion 136T may be formed on a top surface of the first insulation layer 136, the tail portion 136T may represent both edge portions adjacent to the top surface of the first insulation layer 136, and the tail portion 136T of the first insulation layer 136 may have a shape protruding more outward than the bottom surface of the first insulation layer 136 contacting the top surface of the back gate line 130. Both the inner sidewall and the outer sidewall of the spacer 134 may have curved sidewalls along the shape of the tail portion 136T of the first insulation layer 136.

The second end 140E2 of the vertical channel layer 140B contacting the outer sidewall of the spacer 134 may also have a curved sidewall along the shape of the tail portion 136T of the first insulation layer 136. In embodiments, as described with reference to FIGS. 1 to 4, the first sidewall SW1 adjacent to the first end 140E1 of the vertical channel layer 140B has a vertical profile, and the second sidewall SW2 adjacent to the first end 140E1 has a convex curved sidewall toward the corresponding word line WL. In addition, a portion of the first sidewall SW1 adjacent to the second end 140E2 of the vertical channel layer 140B may have a curved shape along the shape of the tail portion 136T of the first insulation layer 136, and a portion of the second sidewall SW2 adjacent to the second end 140E2 of the vertical channel layer 140B may have a curved shape along the shape of the tail portion 136T of the first insulation layer 136.

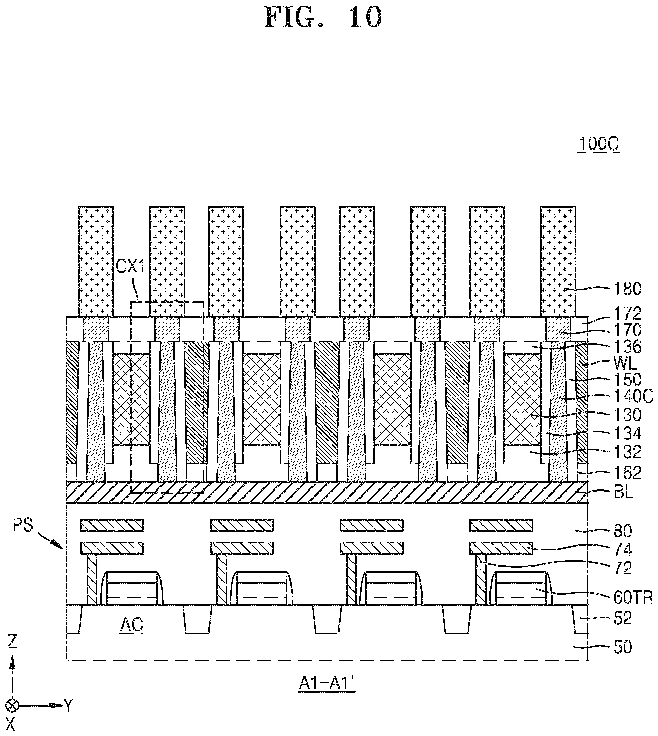

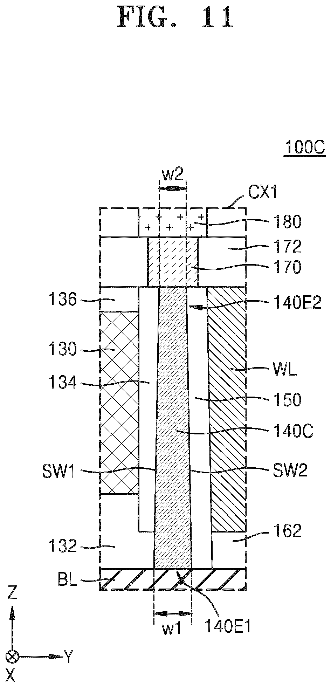

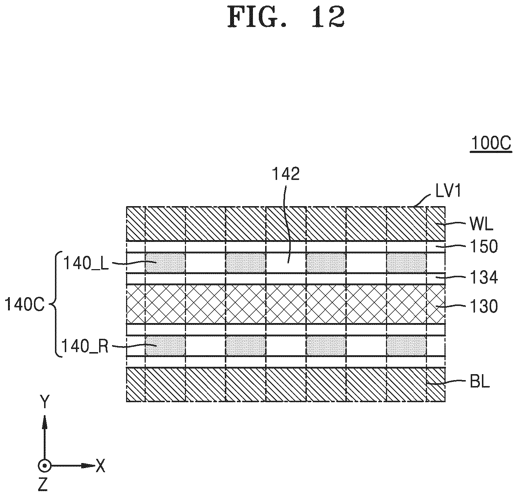

FIG. 10 is a cross-sectional view illustrating a semiconductor device 100C according to embodiments. FIG. 11 is an enlarged view of a portion CX1 of FIG. 10. FIG. 12 is a schematic plan view at a first vertical level LV1 of FIG. 10. In FIGS. 10 to 12, the same reference numerals as in FIGS. 1 to 9 indicate the same components.

Referring to FIGS. 10 to 12, a vertical channel layer 140C may include a first end 140E1 in contact with the bit line BL and a second end 140E2 in contact with the contact pad 170, and a first width w1 of the first end 140E1 may be greater than a second width w2 of the second end 140E2 in the second horizontal direction Y.

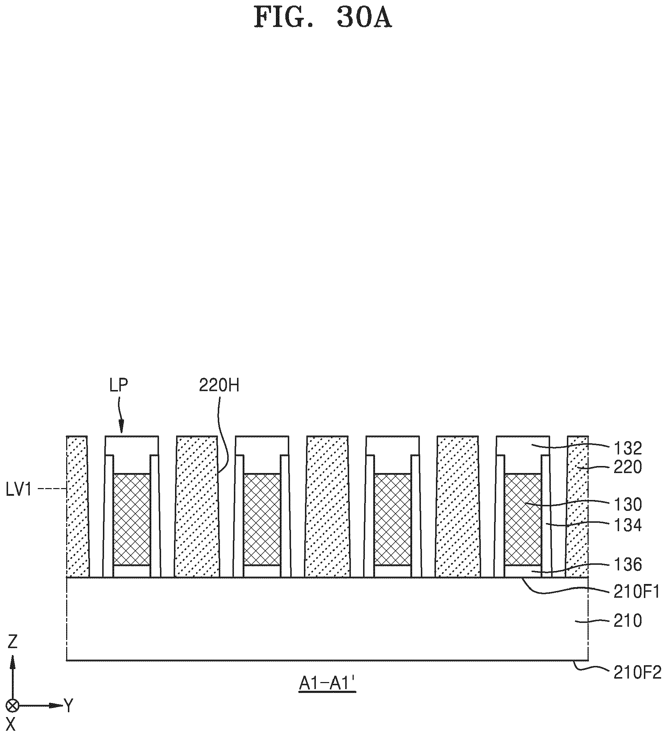

In embodiments, the vertical channel layer 140C may be formed by an epitaxy growth process using the top surface of a substrate 210 as a seed layer in an opening 220H (see FIG. 30A) of a protective layer 220 (see FIG. 30A) formed on the substrate 210 (see FIG. 30A). In some other embodiments, the vertical channel layer 140C may be formed by forming a preliminary channel layer 140P2 using amorphous silicon in the opening 220H of the protective layer 220 and performing a laser annealing process on the preliminary channel layer 140P2, and the vertical channel layer 140C may include single crystallized silicon crystallized in the laser annealing process.

In some embodiments, crystal defects such as stacking faults or dislocations may exist inside the vertical channel layer 140C. In some embodiments, crystal defects observed inside the vertical channel layer 140C may be observed by measurement equipment such as a transmission electron microscope (TEM) or a scan electron microscope (SEM). For example, the crystal defects may refer to a local region that has lost regularity, observed inside the single crystal silicon of the vertical channel layer 140C.

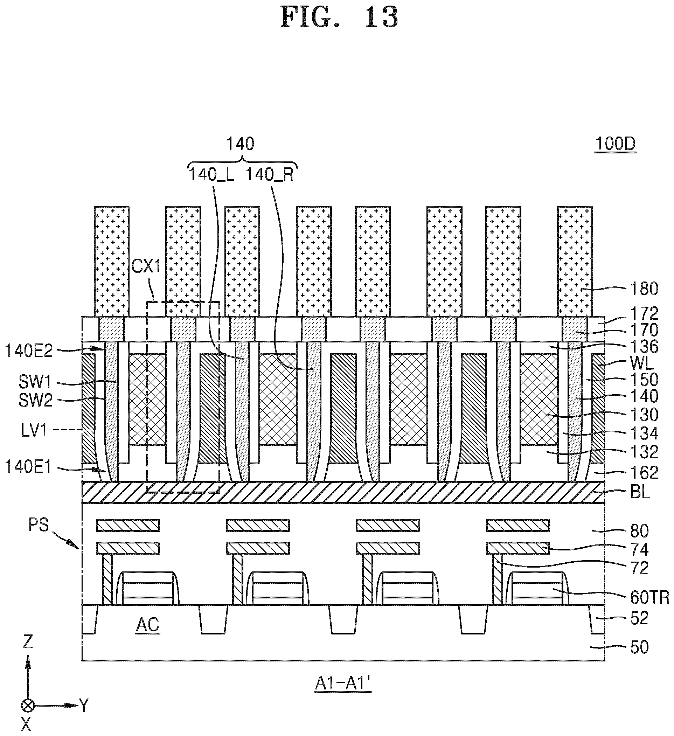

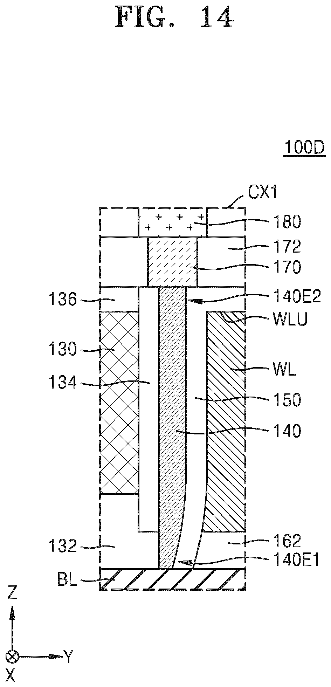

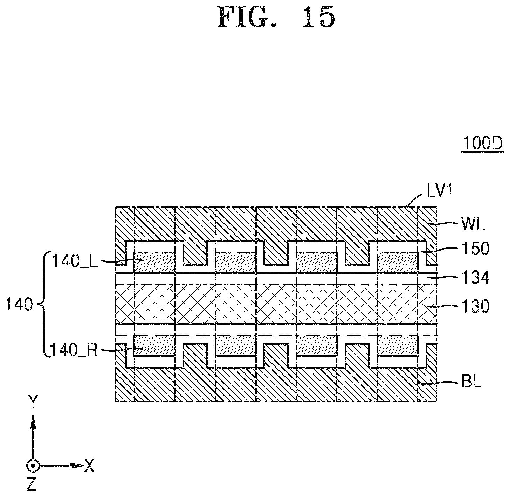

FIG. 13 is a cross-sectional view illustrating a semiconductor device 100D according to embodiments. FIG. 14 is an enlarged view of a portion CX1 of FIG. 13. FIG. 15 is a schematic plan view at a first vertical level LV1 of FIG. 13. In FIGS. 13 to 15, the same reference numerals as in FIGS. 1 to 12 indicate the same components.

Referring to FIGS. 13 to 15, the gate insulation layer 150 may be conformally arranged on the sidewall of the vertical channel layer 140 and may continuously extend onto a top surface WLU of the word line WL on the sidewall of the second end 140E2 of the vertical channel layer 140. The top surface WLU of the word line WL may be covered by the gate insulation layer 150 and may not be in direct contact with the bottom surface of the interlayer insulation layer 172.

As shown in FIG. 15, the channel layer separation insulation layer 142 may be omitted between the vertical channel layers 140 adjacent to each other in the first horizontal direction X, the gate insulation layer 150 may be conformally arranged on the sidewall of the vertical channel layer 140, and a portion of the gate insulation layer 150 may be arranged on the sidewall of the spacer 134. For example, the word line WL may be arranged to fill the space where the channel layer separation insulation layer 142 is omitted, and for example, the word line WL may be arranged to fill the space between two adjacent vertical channel layers 140 in the first horizontal direction X.

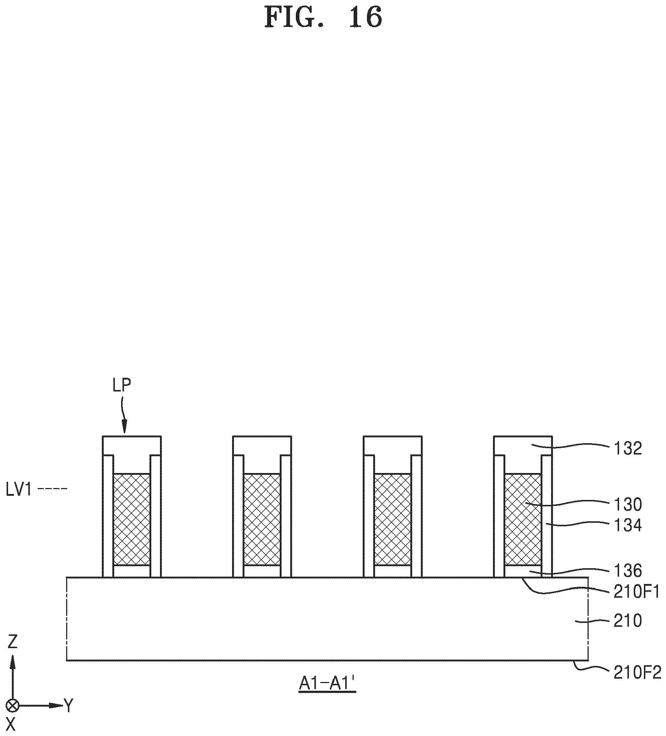

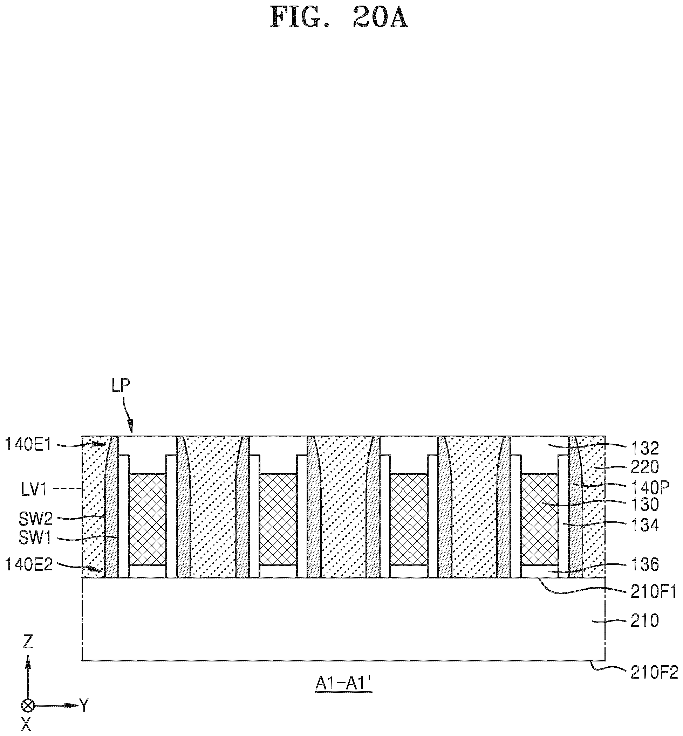

FIGS. 16 to 19, 20A, 20B, 21A, 21B, 22, 23, 24A, 24B, and 25 to 28 are schematic diagrams illustrating a method of manufacturing a semiconductor device 100, according to embodiments, in which FIGS. 16 to 19, 20A, 21A, 22, 23, 24A, and 25 to 28 are cross-sectional views taken along line A1-A1' of FIG. 2, and FIGS. 20B, 21B, and 24B are plan views at a first vertical level LV1 of FIGS. 20A, 21A, and 24A.

Referring to FIG. 16, a stack pattern of the first insulation layer 136 and the back gate line 130 extending in the first horizontal direction X may be formed on a first surface 210F1 of a substrate 210 including a first surface 210F1 and a second surface 210F2. In embodiments, the substrate 210 may include a single crystal silicon substrate.

A spacer 134 may be formed on either sidewall of the first insulation layer 136 and the back gate line 130, and the buried insulation layer 132 covering the top surface of the back gate line 130 may be formed on the top surface of the back gate line 130. In embodiments, the buried insulation layer 132 may be formed to a height covering the top surface of the spacer 134 in the vertical direction Z and may have a T-shaped vertical cross-sectional shape. The first insulation layer 136 may be formed using silicon oxide, and the buried insulation layer 132 may be formed using silicon nitride.

In embodiments, the back gate line 130 may be formed using Ti, TiN, Ta, TaN, Mo, MoN, Ru, W, WN, Co, TiSiN, WSiN, or a combination thereof. In embodiments, the back gate line 130 may be formed in a double layer structure of a conductive barrier layer and a metal buried layer, and in this case, the conductive barrier layer may be formed thinly on the inner wall of the spacer 134 and the top surface of the first insulation layer 136, the metal buried layer may be filled on the conductive barrier layer, and the top side of the metal buried layer may be planarized to form the back gate line 130.

In some embodiments, a mold layer containing polysilicon or amorphous silicon may be formed on the substrate 210, a portion of the mold layer may be removed to form a mold opening, and an oxidation process may be performed on the inner wall of the mold opening to form the spacer 134. Thereafter, the first insulation layer 136, the back gate line 130, and the buried insulation layer 132 may be sequentially formed on the inner wall of the spacer 134 and inside the mold opening, and the mold layer may be removed.

Accordingly, the line pattern LP included in the first insulation layer 136, the back gate line 130, the spacer 134, and the buried insulation layer 132 is arranged on the first surface 210F1 of the substrate 210 to extend in the first horizontal direction X, and the first surface 210F1 of the substrate 210 is exposed in a space between adjacent line patterns LP.

Referring to FIG. 17, a preliminary channel layer 140P may be formed on the top surface and both sidewalls of the line pattern LP and on the first surface 210F1 of the substrate 210.

In embodiments, the preliminary channel layer 140P may include amorphous silicon. The preliminary channel layer 140P may be formed with a conformal thickness on the top surface and both sidewalls of the line pattern LP and on the first surface 210F1 of the substrate 210.

A portion of the preliminary channel layer 140P arranged on the sidewall of the line pattern LP includes a first sidewall SW1 and a second sidewall SW2. The first sidewall SW1 is in contact with the spacer 134 and extends in the first horizontal direction X. The second sidewall SW2 is arranged opposite to the first sidewall SW1 and may extend in the first horizontal direction X. In addition, another portion of the preliminary channel layer 140P may be arranged in contact with the first surface 210F1 of the substrate 210.

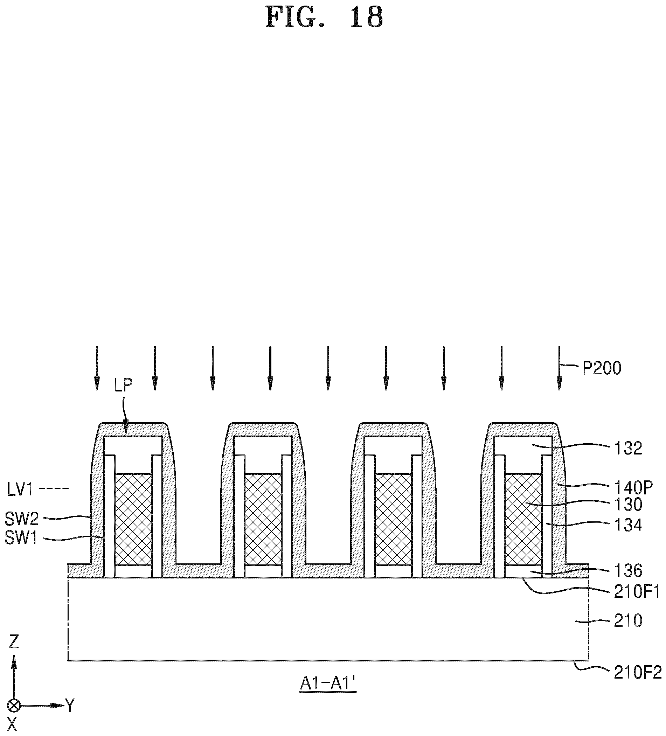

Referring to FIG. 18, a laser annealing process P200 may be performed on the preliminary channel layer 140P. By performing a laser annealing process P200 on the preliminary channel layer 140P, the amorphous silicon of the preliminary channel layer 140P may be melted and annealed to be crystallized, thereby crystallizing the preliminary channel layer 140P into single crystal silicon. In the laser annealing process P200, the first surface 210F1 of the substrate 210 in contact with the bottom surface of the preliminary channel layer 140P acts as a template, and the preliminary channel layer 140P may be crystallized into single crystal silicon with the same crystal structure as the substrate 210.

In embodiments, the laser annealing process P200 may be performed by applying a pulsed laser with a wavelength of several hundred nanometers for several nanoseconds to several tens of nanoseconds.

In embodiments, when the preliminary channel layer 140P is crystallized from amorphous to crystalline silicon by the laser annealing process P200, crystal defects such as stacking faults or dislocations may be generated in the preliminary channel layer 140P.

Referring to FIG. 19, a portion of the preliminary channel layer 140P may be removed to have the preliminary channel layer 140P remain on the sidewall of the line pattern LP.

In embodiments, an anisotropic etching process may be performed on the preliminary channel layer 140P to remove a portion of the preliminary channel layer 140P on the top surface of the line pattern LP and a portion of the preliminary channel layer 140P on the first surface 210F1 of the substrate 210, and the preliminary channel layer 140P may remain on the sidewall of the line pattern LP. After performing the anisotropic etching process, the preliminary channel layer 140P may have the second end 140E2 arranged on the first surface 210F1 of the substrate 210 and the first end 140E1 arranged opposite to the second end 140E2 and arranged at a vertical level higher than the second end 140E2. In the anisotropic etching process, a portion of the first end 140E1 may be exposed to an etching atmosphere to be removed, and the second sidewall SW2 adjacent to the first end 140E1 may have a curved shape.

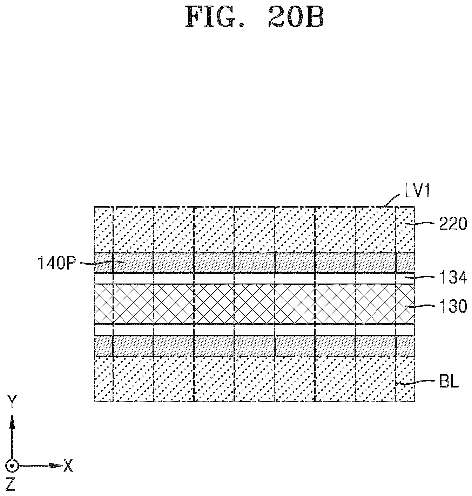

Referring to FIGS. 20A and 20B, a protective layer 220 filling spaces between the line patterns LP may be formed. The protective layer 220 may be formed using at least one of silicon oxide, spin-on hard mask, silicon carbide, a low-k dielectric material, and an amorphous carbon layer.

In embodiments, the top side of the protective layer 220 may be removed so that the top surface of the protective layer 220 may be arranged coplanar with the top surface of the preliminary channel layer 140P and the top surface of the buried insulation layer 132.

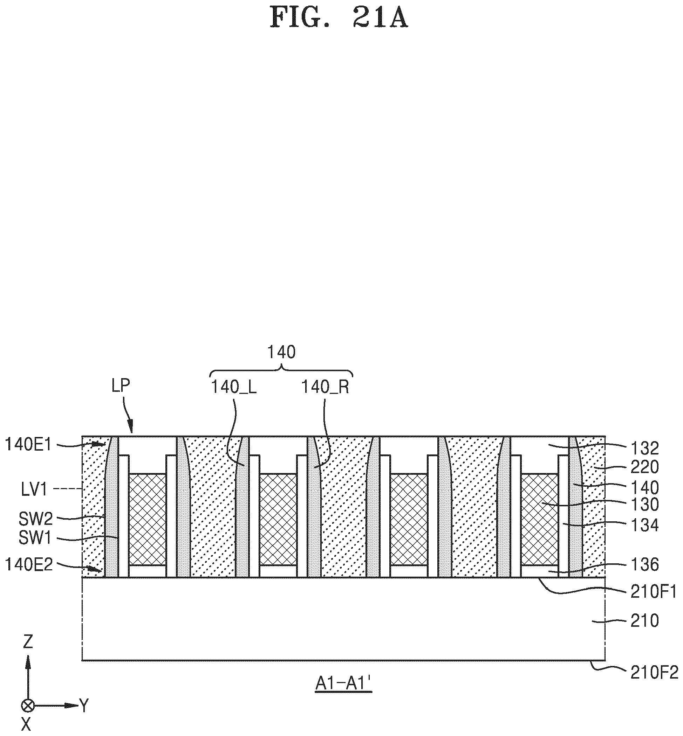

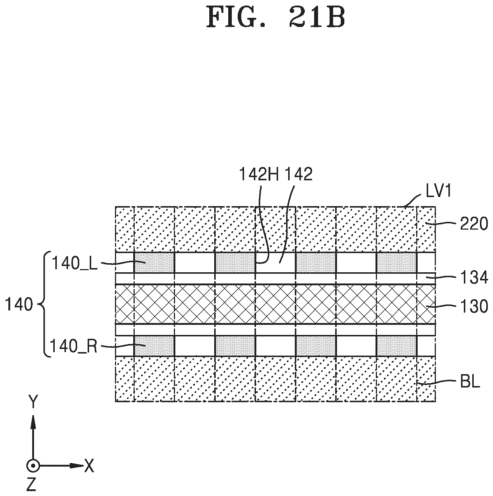

Referring to FIGS. 21A and 21B, mask patterns may be formed on the top surface of the preliminary channel layer 140P, the top surface of the buried insulation layer 132, and the top surface of the protective layer 220, and an opening 142H may be formed by removing a portion of the preliminary channel layer 140P using the mask pattern as an etching mask. The preliminary channel layer 140P may be separated into a plurality of vertical channel layers 140 spaced apart in the first horizontal direction X by the formation of the opening 142H.

Thereafter, the channel layer separation insulation layer 142 may be formed using an insulation material in the opening 142H. For example, the channel layer separation insulation layer 142 may be arranged between two adjacent vertical channel layers 140 in the first horizontal direction X.

As illustrated in FIG. 21B, the vertical channel layer 140 may include a first vertical channel layer 140_L arranged on a first side of one back gate line 130 and a second vertical channel layer 140_R arranged on a second side of one back gate line 130, and the first vertical channel layer 140_L and the second vertical channel layer 140_R may have a mirror symmetrical shape with respect to each other along the center line of the back gate line 130 arranged between the first vertical channel layer 140_L and the second vertical channel layer 140_R.

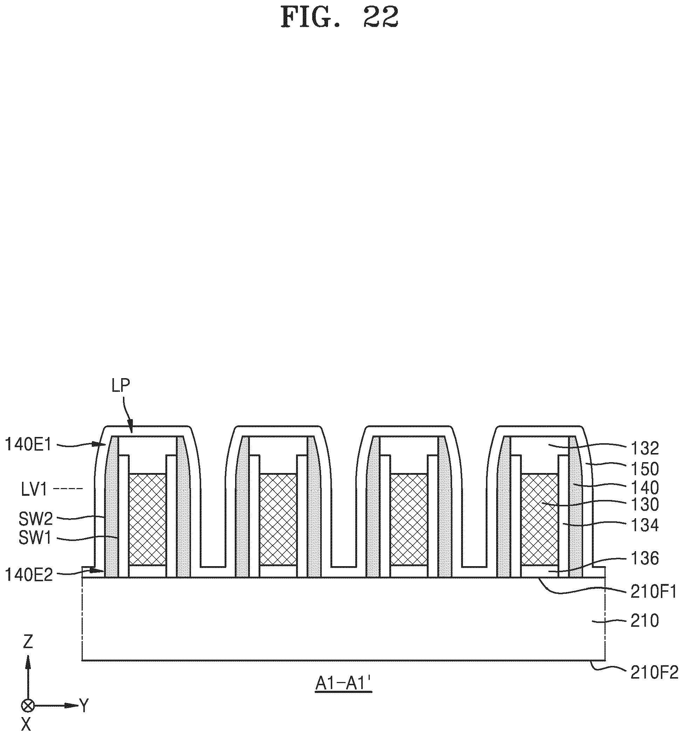

Referring to FIG. 22, the protective layer 220 may be removed.

Thereafter, a gate insulation layer 150 may be formed on the line pattern LP and the vertical channel layers 140.

In embodiments, the gate insulation layer 150 may be formed of at least one selected from silicon oxide, a high-k dielectric material having a dielectric constant higher than that of silicon oxide, and a ferroelectric material. In some embodiments, the gate insulation layer 150 may be formed of at least one selected from hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), silicon oxynitride (ZrON), zirconium silicon oxynitride (ZrSiON), tantalum oxide (TaO), titanium oxide (TiO), barium strontium titanium oxide (BaSrTiO), barium titanium oxide (BaTiO), lead titanate zirconate (PbZrTiO), tantalate strontium bismuth (SrTaBiO), bismuth iron oxide (BiFeO), strontium titanium oxide (SrTiO), yttrium oxide (YO), aluminum oxide (AlO), and lead scandium tantalum oxide (PbScTaO).

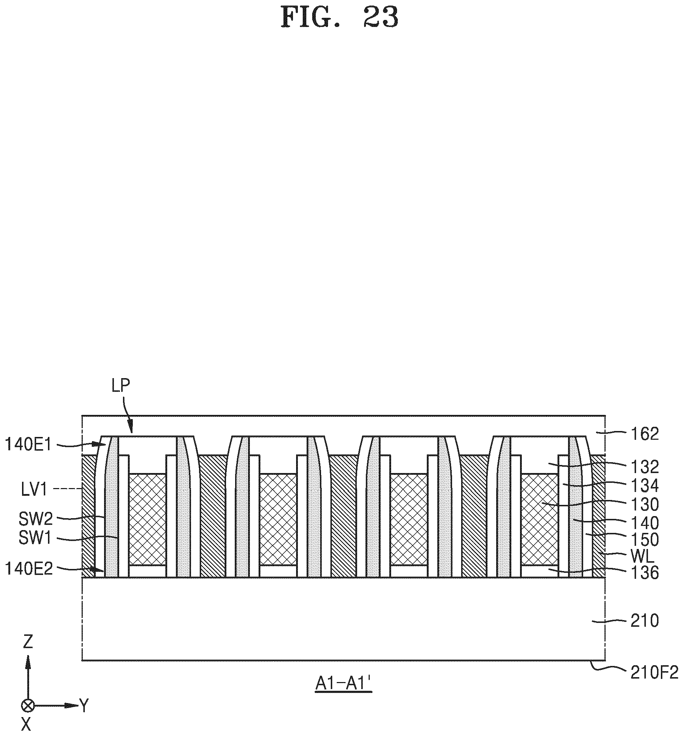

Referring to FIG. 23, a portion of the gate insulation layer 150 arranged on the top surface of the line pattern LP and on the first surface 210F1 of the substrate 210 may be removed, and only a portion of the gate insulation layer 150 arranged on the sidewall of the line pattern LP may remain.

Thereafter, a word line WL may be formed on the sidewall of the gate insulation layer 150. In some embodiments, the word line WL may include Ti, TiN, Ta, TaN, Mo, Ru, W, WN, TiSiN, WSiN, polysilicon, or a combination thereof.

A recess process may be performed on a portion of the upper side of the word line WL to lower the top surface of the word line WL to a level lower than the top surface of the gate insulation layer 150 and the top surface of the vertical channel layer 140, and a second insulation layer 162 may be formed on the top surface of the word line WL. The second insulation layer 162 may be formed using silicon nitride.

In embodiments, the second insulation layer 162 may be formed to cover the line patterns LP and the top surfaces of the vertical channel layers 140.

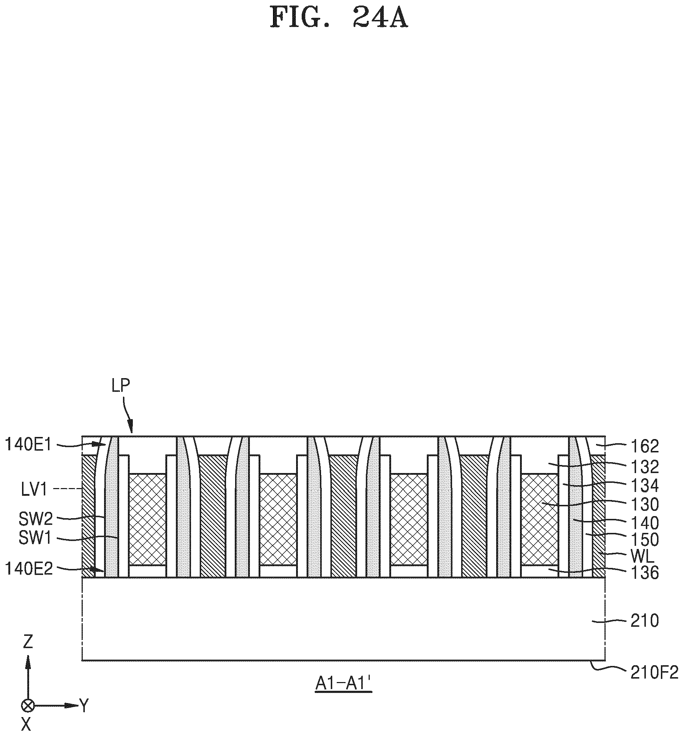

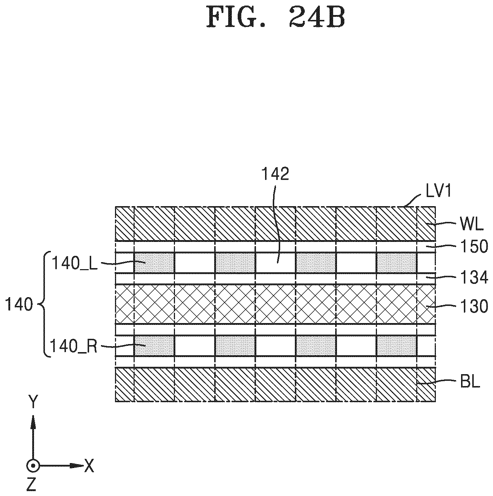

Referring to FIGS. 24A and 24B, the top surfaces of the line pattern LP and the vertical channel layer 140 may be exposed by planarizing the upper side of the second insulation layer 162.

Thereafter, impurity ions may be injected through the top surface of the vertical channel layer 140 to form a source/drain region within the first end 140E1 of the vertical channel layer 140.

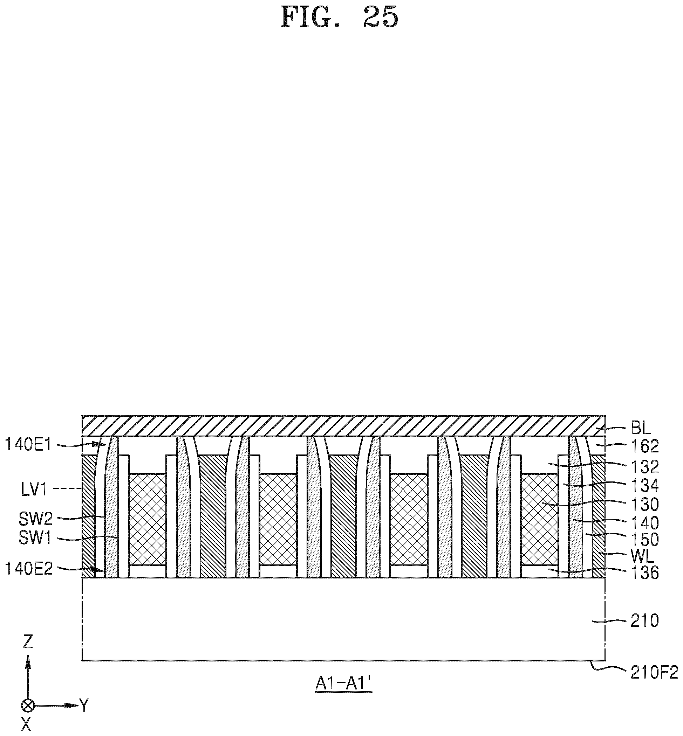

Referring to FIG. 25, a plurality of bit lines BL extending in the second horizontal direction Y may be formed on the first end 140E1 of the vertical channel layer 140, and bit line isolation layers may be formed in spaces between the plurality of bit lines BL.

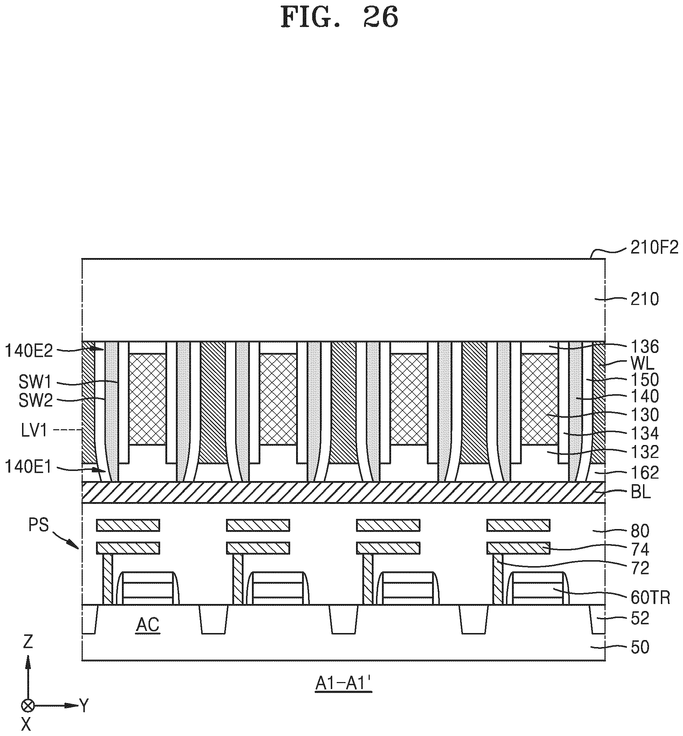

Referring to FIG. 26, a peripheral circuit structure PS may be prepared.

The peripheral circuit structure PS may be prepared by forming a device isolation layer (i.e. device separator) 52 and an active region AC on the substrate 50, and forming a peripheral circuit transistor 60TR, a peripheral circuit contact 72, a peripheral circuit wiring layer 74, and an interlayer insulation layer 80 on the substrate 50.

Subsequently, the substrate 210 may be attached to the peripheral circuit structure PS so that the plurality of bit lines BL are arranged on the peripheral circuit structure PS.

In embodiments, the attachment of the substrate 210 to the peripheral circuit structure PS may be performed by a wafer bonding method such as an oxide bonding method or a metal-oxide hybrid bonding method.

Thereafter, the structure in which the substrate 210 and the peripheral circuit structure PS are attached to each other may be overturned so that the second surface 210F2 of the substrate 210 faces upward.

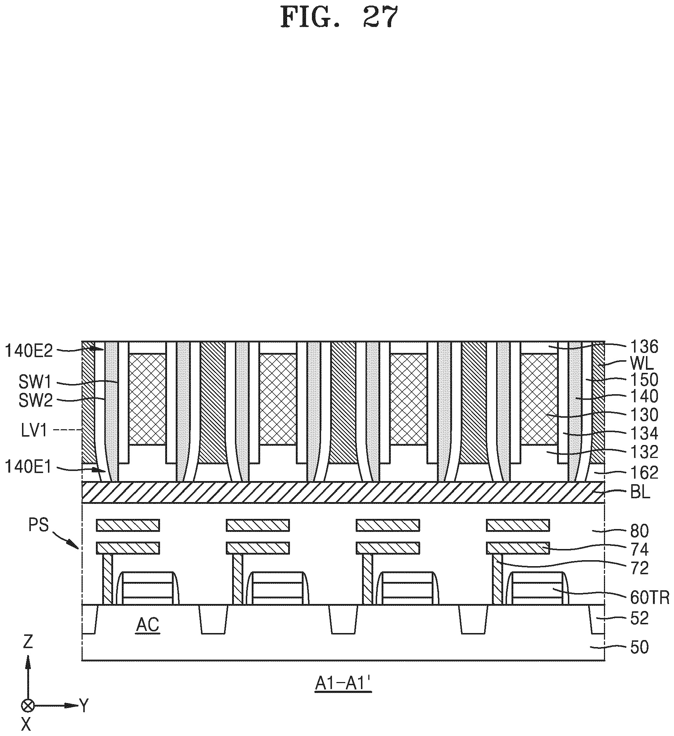

Referring to FIG. 27, the substrate 210 may be removed.

In embodiments, the removal process of the substrate 210 may be performed by grinding, wet etching, and a combination thereof. The substrate 210 may be removed and the second end 140E2 of the vertical channel layer 140 and the top surface of the word line WL may be exposed.

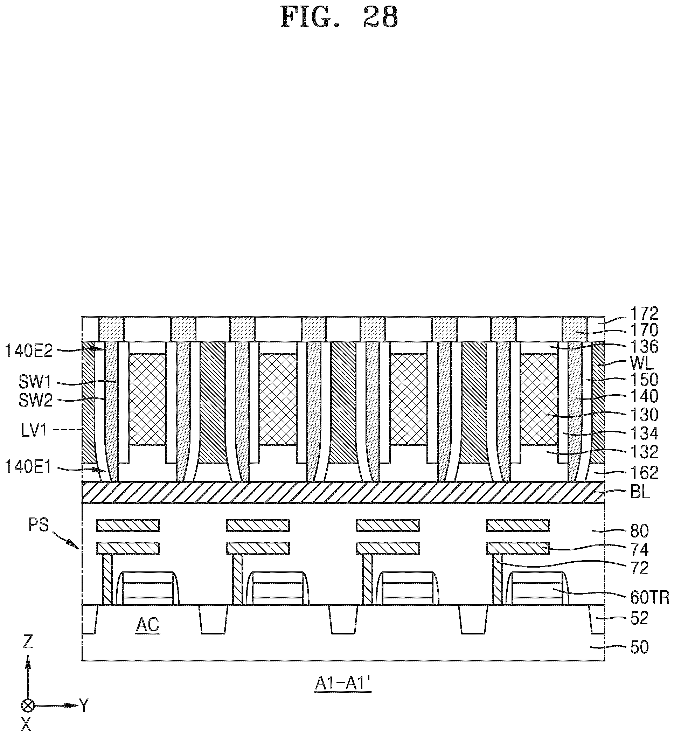

Referring to FIG. 28, an interlayer insulation layer 172 may be formed on the vertical channel layer 140 and the word line WL, and an opening exposing the top surface of the vertical channel layer 140 may be formed by removing a portion of the interlayer insulation layer 172. Thereafter, the contact pad 170 may be formed in the opening. The contact pad 170 may include Ti, TiN, Ta, TaN, Mo, MoN, Ru, W, WN, Co, TiSiN, WSiN, polysilicon, or a silicide material thereof.

In embodiments, a source/drain region may be formed by injecting impurity ions into the upper side of the exposed vertical channel layer 140 before forming the contact pad 170.

Referring back to FIG. 3, a storage node 180 may be formed on the contact pad 170.

The semiconductor device 100 may be completely formed by performing the above-described process.

In general, a vertical channel is formed by etching a silicon layer using an SOI-type substrate to implement a vertical channel transistor. However, since etching damage to the silicon layer occurs during the etching process, the crystal quality of the vertical channel may not be high and/or the electrical characteristics of the vertical channel transistor may not be high. In addition, when using an SOI-type substrate, manufacturing costs may be expensive.

However, according to embodiments, the preliminary channel layer 140P may be formed using amorphous silicon on the sidewall of the line pattern LP, and the laser annealing process P200 may be performed on the preliminary channel layer 140P to crystallize amorphous silicon into single crystal silicon, thereby forming the vertical channel layer 140. Therefore, since the vertical channel layer 140 is not subjected to etching damage, electrical characteristics of the vertical channel transistor may be improved. In addition, manufacturing costs may be reduced.

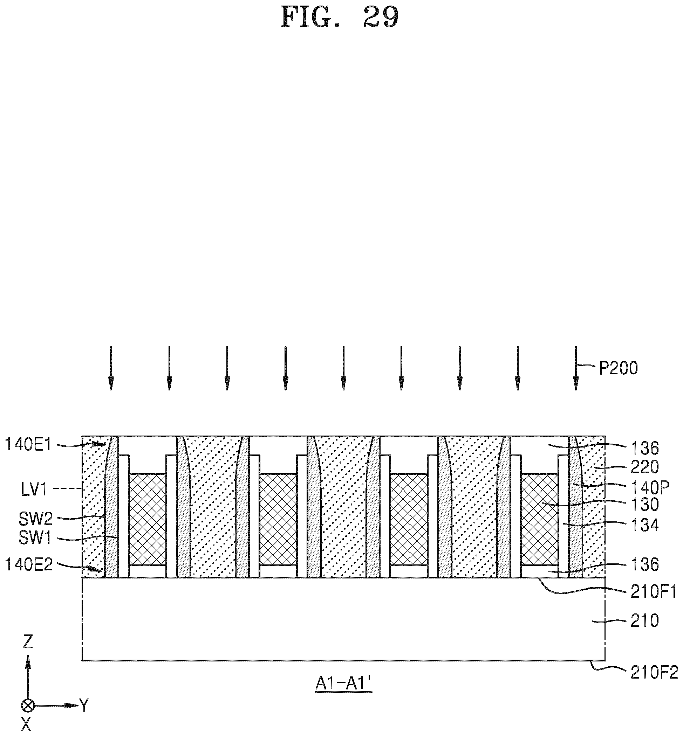

FIG. 29 is a cross-sectional view illustrating a method of manufacturing a semiconductor device 100, according to embodiments.

Referring to FIG. 29, the laser annealing process P200 may not be performed on the preliminary channel layer 140P but may be performed in a state in which the preliminary channel layer 140P remains only on the sidewall of the line pattern LP and the protective layer 220 is filled in the space between the preliminary channel layers 140P.

For example, the preliminary channel layer 140P may be formed by performing the processes described with reference to FIGS. 16 and 17, and then performing the processes described with reference to FIG. 19. In this case, since the laser annealing process P200 is not performed on the preliminary channel layer 140P, the preliminary channel layer 140P may include amorphous silicon. Thereafter, the protective layer 220 may be formed on the first surface 210F1 of the substrate 210 by performing the process described with reference to FIGS. 20A and 20B.

Thereafter, the laser annealing process P200 may be performed on the top surface of the preliminary channel layer 140P. The laser annealing process P200 may be performed by applying a pulsed laser with a wavelength of, for example, several hundred nanometers for several nanoseconds to several tens of nanoseconds.

By performing the laser annealing process P200 on the preliminary channel layer 140P, the amorphous silicon of the preliminary channel layer 140P may be melted and annealed to be crystallized, thereby crystallizing the preliminary channel layer 140P into single crystal silicon. In the laser annealing process P200, the first surface 210F1 of the substrate 210 in contact with the bottom surface of the preliminary channel layer 140P acts as a template, and the preliminary channel layer 140P may be crystallized into single crystal silicon with the same crystal structure as the substrate 210.

In some other embodiments, the laser annealing process P200 may be performed after the preliminary channel layer 140P is separated into a plurality of vertical channel layers 140 spaced apart in the first horizontal direction X by performing the process described with reference to FIGS. 21A and 21B.

Thereafter, the semiconductor device 100 may be completely formed by performing the process described with reference to FIGS. 22 to 28.

In some other embodiments, in the process described with reference to FIG. 23, upper sides of the word line WL may be further removed in the recess process so that the top surface of the word line WL is placed at the same level as the top surface of the back gate line 130. Afterwards, when a planarization process is performed on the upper side of the second insulation layer 162 in the process described with reference to FIGS. 24A and 24B, the top surface of the second insulation layer 162 may be planarized to be arranged at the same level as the top surface of the spacer 134. In this case, a curved sidewall portion arranged at the first end 140E1 of the vertical channel layer 140 may be removed together in the planarization process, and a top surface area of the vertical channel layer 140 may be relatively large. In this case, the semiconductor device 100A described with reference to FIGS. 6 and 7 may be manufactured.

In some other embodiments, when the first insulation layer 136 and the back gate line 130 are formed in the process described with reference to FIG. 16, a mask pattern may be formed on the back gate line 130 after the first insulation layer 136 and the back gate line 130 are sequentially formed, and the back gate line 130 and the first insulation layer 136 may be patterned using the mask pattern as an etching mask. In the patterning process, the tail portion 136T may be formed on a portion of the first insulation layer 136 adjacent to the first surface 210F1 of the substrate 210, and then portions of the spacer 134 and the preliminary channel layer 140P may be formed to have a curved sidewall along the shape of the tail portion 136T of the first insulation layer 136, in the process of forming the spacer 134 and the preliminary channel layer 140P. In this case, the semiconductor device 100B described with reference to FIGS. 8 and 9 may be manufactured.

In some other embodiments, the channel layer separation insulation layer 142 may not be formed in the process described with reference to FIG. 22, and a portion of the gate insulation layer 150 arranged on the first surface 210F1 of the substrate 210 may not be removed and a word line WL may be formed on the portion of the gate insulation layer 150 in the process described with reference to FIG. 23. In this case, the semiconductor device 100D described with reference to FIGS. 13 to 15 may be manufactured.

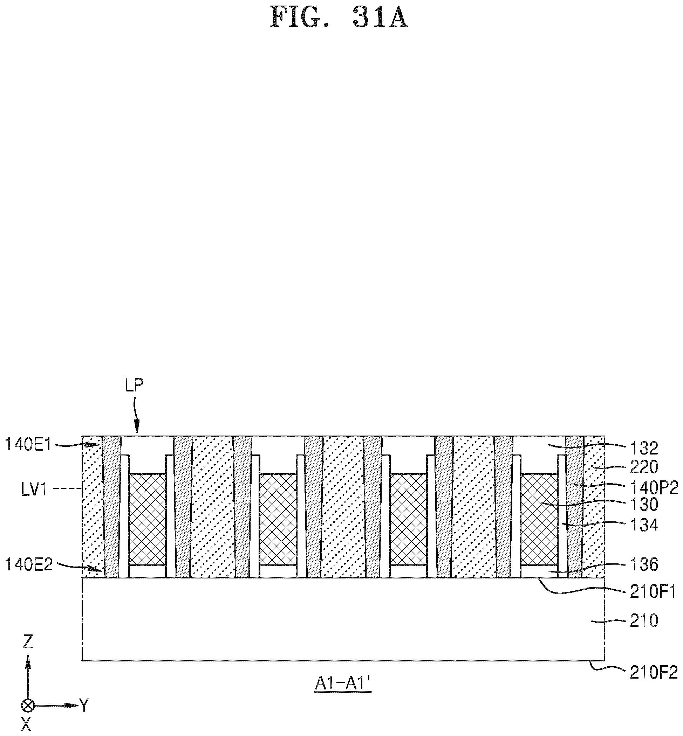

FIGS. 30A, 30B, 31A, 31B, and 32 are schematic diagrams illustrating a method of manufacturing a semiconductor device 100C, according to embodiments, in which FIGS. 30A, 31A, and 32 are cross-sectional views taken along line A1-A1' of FIG. 2, and FIGS. 30B and 31B are plan views at a first vertical level of FIGS. 30A and 31A.

First, a line pattern LP may be formed on the first surface 210F1 of the substrate 210 by performing the process described with reference to FIG. 16.

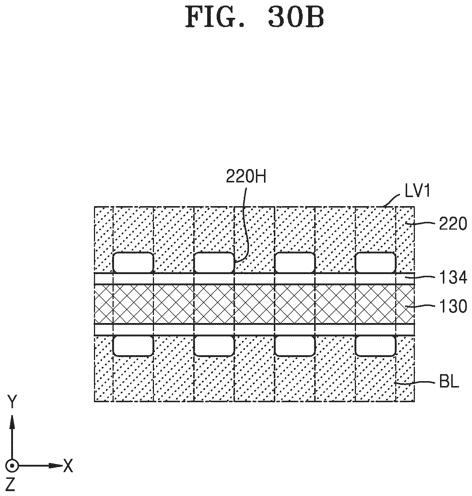

Referring to FIGS. 30A and 30B, a protective layer 220 may be formed in a space between the line patterns LP. Thereafter, a mask pattern may be formed on the protective layer 220, and a portion of the protective layer 220 may be removed using the mask pattern as an etching mask to form an opening 220H. The first surface 210F1 of the substrate 210 may be exposed at the bottom of the opening 220H, and the opening 220H may be arranged to expose the sidewall of the spacer 134 at the inner wall of the opening 220H.

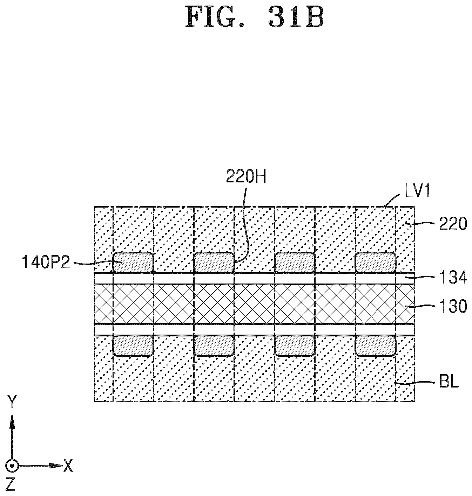

Referring to FIGS. 31A and 31B, the preliminary channel layer 140P2 may be formed using amorphous silicon on the first surface 210F1 of the substrate 210 in the opening 220H of the protective layer 220.

In embodiments, after the preliminary channel layer 140P2 fills the inside of the opening 220H of the protective layer 220, a planarization process is further performed on the upper side of the preliminary channel layer 140P2 so that the preliminary channel layer 140P2 has a flat top surface in which the second end 140E2 of the preliminary channel layer 140P2 is arranged at the same level as the top surface of the protective layer 220.

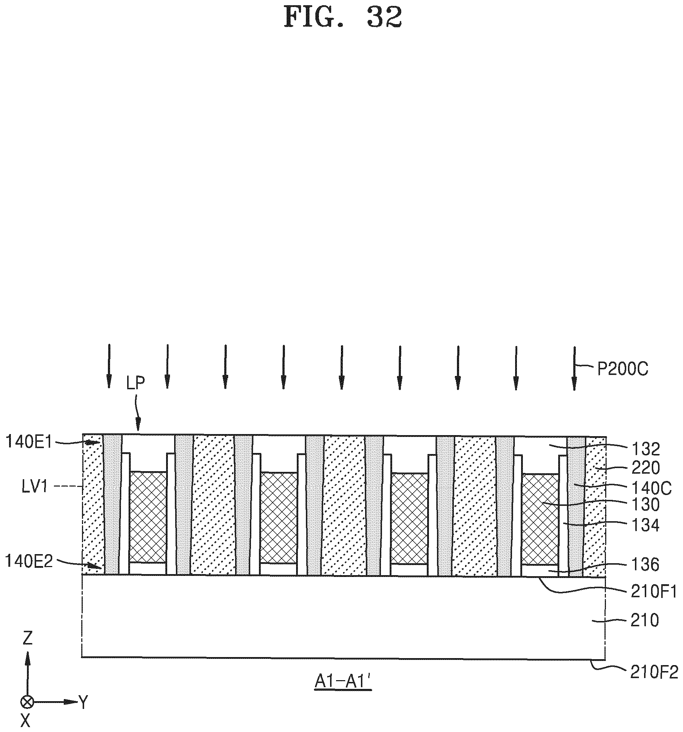

Referring to FIG. 32, a laser annealing process P200C may be performed on the top surface of the preliminary channel layer 140P2. The laser annealing process P200C may be performed by applying a pulsed laser with a wavelength of, for example, several hundred nanometers for several nanoseconds to several tens of nanoseconds.

By performing the laser annealing process P200C on the preliminary channel layer 140P2, the amorphous silicon of the preliminary channel layer 140P2 may be melted and annealed to be crystallized, thereby crystallizing the preliminary channel layer 140P2 into single crystal silicon. In the laser annealing process P200C, the first surface 210F1 of the substrate 210 in contact with the bottom surface of the preliminary channel layer 140P2 may act as a template, and the preliminary channel layer 140P2 may be crystallized into single crystal silicon with the same crystal structure as the substrate 210. The preliminary channel layer 140P2 melted, annealed, and/or crystallized by the laser annealing process P200C may be referred to as a vertical channel layer 140C.

In some other embodiments, the preliminary channel layer 140P2 may be formed by an epitaxy growth process using the first surface 210F1 of the substrate 210 as a seed layer in the opening 220H of the protective layer 220. In embodiments, the epitaxy growth process for forming the preliminary channel layer 140P2 may be performed by supplying a liquid or vapor silicon precursor as a source material. In this case, the laser annealing process P200C described with reference to FIG. 32 may be additionally performed or omitted.

The protective layer 220 is then removed, and the channel layer separation insulation layers 142 (see FIG. 12) may be formed between the plurality of vertical channel layers 140C.

Thereafter, the semiconductor device 100C may be completely manufactured by performing the process described with reference to FIGS. 22 to 28.

## Claims

1. A semiconductor device (100) comprising;
a peripheral circuit structure (PS) comprising peripheral circuit transistors (60TR);
a plurality of bit lines (BL) on the peripheral circuit structure (PS) and extending in a first horizontal direction (Y);
a plurality of back gate lines (130) extending in a second horizontal direction (X) at a vertical level higher than a vertical level of the plurality of bit lines (BL);
a plurality of word lines (WL) extending in the second horizontal direction (X) at a vertical level higher than the vertical level of the plurality of bit lines (BL) and alternating with the plurality of back gate lines (130);
a plurality of vertical channel layers (140) in a matrix form on the plurality of bit lines (BL), each of the plurality of vertical channel layers (140) comprising a first sidewall (SW1) extending in a vertical direction (Z) and facing a corresponding back gate line among the plurality of back gate lines (130), a second sidewall opposite to the first sidewall (SW1) and facing a corresponding word line among the plurality of word lines (WL), a part of the second sidewall (SW2) adj acent to a bit line (BL) among the plurality of bit lines (BL) having a curved shape;
a plurality of contact pads (170) on the plurality of vertical channel layers (140); and
a plurality of storage nodes (180) on the plurality of contact pads (170).

2. The semiconductor device (100) of claim 1, wherein each of the plurality of vertical channel layers (140) comprises a first end (140E1) contacting the bit line (BL) and a second end (140E2) opposite to the first end (140E1), and
wherein a first width of the first end (140E1) in the first horizontal direction (Y) is less than a second width of the second end (140E2) in the first horizontal direction (Y).

3. The semiconductor device (100) of claim 2, wherein the second sidewall (SW2) of each of the plurality of vertical channel layers (140) has a convex curved shape toward the corresponding word line at a position adjacent to the first end (140E1).

4. The semiconductor device (100) of claim 3, further comprising:
a gate insulation layer (150) between each of the plurality of vertical channel layers (140) and the corresponding word line among the plurality of word lines (WL),
wherein the gate insulation layer (150) is on the convex curved shape of the second sidewall (SW2) of a vertical channel layer (140) among the plurality of vertical channel layers (140).

5. The semiconductor device (100) of any one of claims 2 to 4, further comprising:
a spacer (134) between each of the plurality of vertical channel layers (140) and the corresponding back gate line among the plurality of back gate lines (130),
wherein the spacer (134) extends in the vertical direction (Z) on the first sidewall (SW1) of a vertical channel layer (140) among the plurality of vertical channel layers (140).

6. The semiconductor device (100) of any one of claims 1 to 5, wherein the plurality of vertical channel layers (140) comprise single crystal silicon.

7. The semiconductor device (100) of any one of claims 1 to 6, wherein a stacking fault or a dislocation is included in the plurality of vertical channel layers (140).

8. The semiconductor device (100) of any one of claims 1 to 7, wherein the plurality of vertical channel layers (140) comprise:
a first vertical channel layer (140_L) on a first side of each of the plurality of back gate lines (130); and
a second vertical channel layer (140_R) on a second side of each of the plurality of back gate lines (130), and adjacent to the first vertical channel layer (140_L) in the first horizontal direction (Y),
wherein the first vertical channel layer (140_L) and the second vertical channel layer (140_R) are symmetrical with respect to each other.

9. A semiconductor device (100) comprising:
a plurality of bit lines (BL) on a substrate (50) and extending in a first horizontal direction (Y);
a plurality of back gate lines (130) extending in a second horizontal direction (X) at a vertical level higher than a vertical level of the plurality of bit lines (BL);
a plurality of word lines (WL) extending in the second horizontal direction (X) at a vertical level higher than the vertical level of the plurality of bit lines (BL) and alternating with the plurality of back gate lines (130);
a plurality of vertical channel layers (140) extending in a vertical direction (Z) on the plurality of bit lines (BL), each of the plurality of vertical channel layers (140) comprising a first sidewall (SW1) extending in the vertical direction (Z) and facing a corresponding back gate line among the plurality of back gate lines (130), a second sidewall opposite to the first sidewall (SW1) and facing a corresponding word line among the plurality of word lines (WL), a first end (140E1) in contact with a bit line (BL) among the plurality of bit lines (BL), and a second end (140E2) opposite to the first end (140E1), the second sidewall (SW2) having a convex curved shape toward the corresponding word line among the plurality of word lines (WL) at a position adjacent to the first end (140E1);
a plurality of contact pads (170) on the plurality of vertical channel layers (140); and
a plurality of storage nodes (180) on the plurality of contact pads (170),
wherein a first width of the first end (140E1) in the first horizontal direction (Y) is less than a second width of the second end (140E2) in the first horizontal direction (Y).

10. The semiconductor device (100) of claim 9, wherein the plurality of vertical channel layers (140) comprise:
a first vertical channel layer (140_L) on a first side of each of the plurality of back gate lines (130); and
a second vertical channel layer (140_R) on a second side of each of the plurality of back gate lines (130), and adjacent to the first vertical channel layer (140_L) in the first horizontal direction (Y),
wherein the first vertical channel layer (140_L) and the second vertical channel layer (140_R) are symmetrical with respect to each other.

11. The semiconductor device (100) of claim 9 or 10, further comprising:
a peripheral circuit structure (PS) between the substrate (50) and the plurality of bit lines (BL), wherein
wherein the peripheral circuit structure (PS) comprises a peripheral circuit transistor (60TR) configured to drive the plurality of bit lines (BL) or the plurality of word lines (WL).

12. The semiconductor device (100) of any one of claims 9 to 11, further comprising:
a gate insulation layer (150) between each of the plurality of vertical channel layers (140) and the corresponding word line; and
a spacer (134) between each of the plurality of vertical channel layers (140) and the corresponding back gate line.

13. The semiconductor device (100) of claim 12, wherein the gate insulation layer (150) is on the convex curved shape of the second sidewall (SW2) of a vertical channel layer (140) among the plurality of vertical channel layers (140), and
wherein the spacer (134) extends in the vertical direction (Z) on the first sidewall (SW1) of the vertical channel layer (140).

14. The semiconductor device (100) of any one of claims 9 to 13, wherein the plurality of vertical channel layers (140) comprise single crystal silicon.

15. The semiconductor device (100) of any one of claims 9 to 14, wherein a stacking fault or a dislocation is included in the plurality of vertical channel layers (140).
